Europäisches Patentamt

European Patent Office

Office européen des brevets

(19)

(11) EP 0 767 961 B1

(12) EUROPÄISCHE PATENTSCHRIFT

(45) Veröffentlichungstag und Bekanntmachung des Hinweises auf die Patenterteilung:
16.09.1998 Patentblatt 1998/38

(21) Anmeldenummer: 95924300.7

(22) Anmeldetag: 21.06.1995

(51) Int Cl.⁶: G11C 19/00, G11C 7/00

(86) Internationale Anmeldenummer:
PCT/EP95/02394

(87) Internationale Veröffentlichungsnummer:
WO 96/00965 (11.01.1996 Gazette 1996/03)

(54) **SCHALTUNGSANORDNUNG MIT WENIGSTENS EINER SCHALTUNGSEINHEIT WIE EINEM REGISTER, EINER SPEICHERZELLE, EINER SPEICHERANORDNUNG ODER DERGLEICHEN**

CIRCUIT ARRANGEMENT WITH A CIRCUIT UNIT SUCH AS A REGISTER MEMORY CELL, MEMORY ARRANGEMENT OR THE LIKE

CIRCUITERIE COMPORTANT AU MOINS UNE UNITE DE CIRCUIT TELLE QU'UN REGISTRE, UNE CELLULE DE MEMOIRE, UN SYSTEME DE MEMORISATION OU SIMILAIRE

(84) Benannte Vertragsstaaten:
BE DE FR GB

(30) Priorität: 29.06.1994 DE 4422784

(43) Veröffentlichungstag der Anmeldung:
16.04.1997 Patentblatt 1997/16

(73) Patentinhaber: Océ Printing Systems GmbH
85586 Poing (DE)

(72) Erfinder:
• ELMER, Werner
D-85368 Moosburg (DE)
• MORRIS, Edward
D-85435 Erding (DE)
• REINER, Robert
D-82008 Unterhaching (DE)
• ROMBACH, Gerd
D-85354 Freising (DE)

(74) Vertreter: Schaumburg, Thoenes, Thurn
Patentanwälte
Postfach 86 07 48
81634 München (DE)

(56) Entgegenhaltungen:
EP-A- 0 351 819       EP-A- 0 431 624
EP-A- 0 432 790       DE-A- 4 409 371
US-A- 4 222 112       US-A- 5 159 573

• PATENT ABSTRACTS OF JAPAN vol. 16 no. 355 (P-1394) ,30.Juli 1992 & JP,A,04 106798 (OKI LECTRIC)
• PATENT ABSTRACTS OF JAPAN vol. 17 no. 509 (P-1612) ,13.September 1993 & JP,A,05 128889 (MATSUSHITA)
• PATENT ABSTRACTS OF JAPAN vol. 7 no. 206 (P-222) [1351] ,10.September 1983 & JP,A,58 102393 (MITSUBISHI)
• IEEE TRANSACTIONS ON NUCLEAR SCIENCE, Bd. 36, Nr. 1, Februar 1989 NEW YORK US, Seiten 512-516, XP 000096681 SASAKI ET AL '1.2 GAAS SHIFT REGISTER IC FOR DEAD-TIME-LESS TDC APPLICATION.'

**Beschreibung**

Die Erfindung betrifft eine Schaltungsanordnung mit wenigstens einer Schaltungseinheit wie einem Register, einer Speicherzelle, einer Speicheranordnung oder dergleichen, die mehrere taktgesteuerte Elementarspeicher enthält, deren Takteingänge mit einer gemeinsamen Taktleitung in Verbindung stehen.

Bei den herkömmlichen Schaltungsanordnungen dieser Art werden die verschiedenen Elementarspeicher stets gleichzeitig getaktet. In der Regel ändern somit gleichzeitig mehrere Elementarspeicher ihren Zustand. Aufgrund der synchronen Schaltvorgänge können relativ hohe momentane Verlustleistungen auftreten, die um so höher sind, je größer die Anzahl der gleichzeitig ihren Zustand ändernden Elementarspeicher ist. Zudem steigt diese Verlustleistung mit der Taktfrequenz an. Insbesondere bei Schaltungseinheiten mit einer großen Anzahl von Elementarspeichern und hoher Taktfrequenz kann es daher zu Einbrüchen und Schwankungen der internen Betriebsspannung kommen, was unter anderem die Gefahr einer fehlerhaften Ansteuerung benachbarter Logikschaltungen und einer Störung analoger Schaltkreise mit sich bringt.

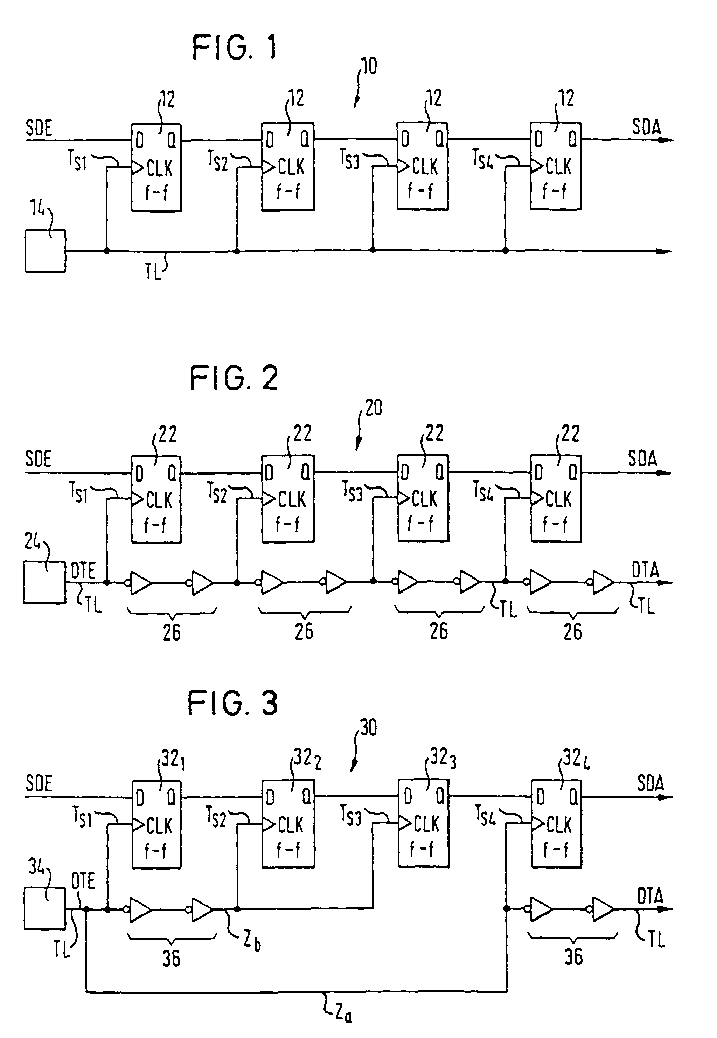

Eine derartige herkömmliche Schaltungseinheit ist in Fig. 1 der Zeichnung gezeigt. Hierbei handelt es sich um ein flankengetriggertes Schieberegister 10, das aus vier hintereinandergeschalteten dynamischen D-Flip-Flops 12 besteht und einen seriellen Dateneingang SDE sowie einen seriellen Datenausgang SDA besitzt. Die Takteingänge CLK der D-Flip-Flops 12 stehen mit einer gemeinsamen Taktleitung TL in Verbindung und sind über diese mit einem Taktgeber 14 verbunden. Hierbei werden die Takteingänge CLK über die Taktleitung TL so vom Taktgeber 14 beaufschlagt, daß die entsprechenden Taktsignale $Ts_1$-$Ts_4$ der verschiedenen D-Flip-Flops 12 gleichzeitig auftreten und die D-Flip-Flops 12 somit synchron angesteuert werden. Bei einem bestimmten Bit-Muster kann somit der Fall auftreten, daß mit einem jeweiligen Taktimpuls die verschiedenen D-Flip-Flops ihren Zustand gleichzeitig ändern.

Beispielsweise im Falle eines typischen CMOS-Schieberegisters ändert sich der Speisestrom $I_{sr}$ linear mit der Betriebsspannung $V_{cc}$, der äquivalenten Schaltungskapazität $C_{eq}$ und der Daten-Taktfrequenz $f_{DAC}$, so daß dieser Speisestrom durch die folgende Beziehung gegeben ist:

$$I_{sr} = C_{eq} \cdot f_{DAC} \cdot V_{cc}.$$

Ein maximaler Schaltstrom tritt dann auf, wenn ein alternierendes Bit-Muster ...1010101... durch das Register geschoben wird. Die angegebene Beziehung zeigt, daß die Verlustleistung linear mit der Taktfrequenz $f_{DAC}$ und der äquivalenten Schaltungskapazität $C_{eq}$ ansteigt, die vom Umfang des Schieberegisters abhängt. Messungen anhand einer Nachbildung eines 5 x 17 Bit-Schieberegisters mit dem in Fig. 1 gezeigten herkömmlichen Aufbau haben bei einer Taktfrequenz von 140 MHz ergeben, daß der mittlere Speisestrom des Schieberegisters zwar nur 13 mA beträgt, während eines gleichzeitigen Schaltens sämtlicher Flip-Flops jedoch Spitzenströme von 85 mA auftreten können. In der nachgebildeten Schaltung erzeugten diese Spitzenströme Spannungsspitzen von 2,9 V Spitze-Spitze, die zwischen den internen $V_{cc}$- und Masse-Leitungen einer integrierten Schaltung auftreten und zu der bereits erwähnten fehlerhaften Ansteuerung benachbarter Logikschaltungen und der Störung von Analogschaltungen führen können.

Es ist weiterhin aus der JP-OS 59-92493 bei integrierten Schaltkreisen mit hintereinander geschalteten Flip-Flops in Form eines Schieberegisters bekannt, die Taktimpulse vom Ende des Registers entgegen der Datenflußrichtung zuzuführen, um so die Taktimpulse in Richtung Dateneingang zu verzögern. Dadurch soll erreicht werden, daß die dem niederrangigsten Flip-Flop zugeführten Datensignale sicher zum höchstrangigsten Flip-Flop übertragen werden. Eine Kette aus mehreren zusammengeschalteten Schaltkreisen läßt sich auf diese Weise jedoch nicht ansteuern, da Daten und Takt in der Kette nicht simultan getaktet werden können.

Aus der EP-A-0 351 819 ist eine Schaltungsanordnung gemäß dem Oberbegriff der Patentansprüche 1 und 13 bekannt. Bei dieser Schaltungsanordnung werden, bedingt durch die Signalverzögerung entlang der Taktleitung, sämtliche Elementarspeicher einer Schieberegisterkette in Datenflußrichtung sequentiell getaktet. Es wird betont, daß es für eine korrekte Funktion des Registers wesentlich ist, daß die Taktverzögerung geringer ist als die Datenlaufzeit. Das Problem auftretender Stromspitzen ist nicht erwähnt.

Die EP-A-0 432 790 zeigt eine Schaltungsanordnung, bei der mehrere Ausgangspuffer seriell aktiviert werden, um auftretende Stromspitzen zu verringern.

Es ist weiterhin aus der US-A-4 222 112 bekannt, daß das Aktivieren von Flip-Flops Stromspitzen bewirkt, deren Amplituden durch serielles Aktivieren verringert werden können.

Ziel der Erfindung ist es, eine Schaltungsanordnung der eingangs genannten Art zu schaffen, bei der das dynamische Schaltrauschen auf einfache und zuverlässige Weise auf ein Minimum herabgesetzt ist.

Diese Aufgabe wird gemäß den Merkmalen der Patentansprüche 1 und 13 gelöst.

Gemäß der Erfindung werden den Elementarspeichern gruppenweise zeitgleiche Taktsignale zugeführt. Eine solche gruppenweise Aktivierung ermöglicht es, die resultierende Laufzeit der Daten durch das Register gering zu halten gegenüber einer individuellen Aktivierung der Zellen, bei gleichzeitiger Reduzierung des Schaltrauschens gegenüber einem Register, dessen sämtliche Zellen gleichzeitig aktiviert werden.

In den Unteransprüchen sind weitere vorteilhafte Ausführungsvarianten der Erfindung angegeben.

Die Erfindung wird im folgenden anhand von Ausführungsbeispielen unter Bezugnahme auf die Zeichnung näher beschrieben; in dieser zeigen:

Fig. 1 ein herkömmliches Schieberegister,

Fig. 2 eine Ausführungsform eines zum Verständnis der Erfindung beitragenden Schiebe-registers.

Fig. 3 eine Ausführungsform eines erfindungsgemäßen Schieberegisters,

Fig. 4 eine weitere Ausführungsform eines erfindungsgemäßen Schieberegisters.

In Fig. 1 ist der eingangs erläuterte Aufbau eines herkömmlichen Schieberegisters gezeigt.

Verschiedene Ausführungsformen einer Schaltungsanordnung werden im folgenden anhand der Figuren 2 bis 4 beschrieben.

Die in Fig. 2 gezeigte Schaltungseinheit ist durch ein Schieberegister 20 gebildet, dessen Elementarspeicher dynamische D-Flip-Flops 22 sind. Beim dargestellten Ausführungsbeispiel sind vier solche D-Flip-Flops 22 vorgesehen, die dadurch miteinander verkettet sind, daß der Q-Ausgang eines vorhergehenden D-Flip-Flops 22 mit dem D-Eingang eines nachfolgenden D-Flip-Flops 22 verbunden ist. Der D-Eingang des ersten D-Flip-Flops 22 bildet den seriellen Dateneingang SDE des Schieberegisters 20, während der serielle Datenausgang SDA dieses Schieberegisters 20 durch den Q-Ausgang des letzten D-Flip-Flops 22 gebildet ist.

Die differenzierenden oder dynamischen Takteingänge CLK der D-Flip-Flops 22 sind über eine gemeinsame Taktleitung TL mit einem Taktgeber 24 verbunden. Die Taktleitung TL enthält vier jeweils durch einen Doppelinverter 26 gebildete Verzögerungsglieder. Die ersten drei Doppelinverter 26 sind jeweils zwischen die Takteingänge CLK zweier aufeinanderfolgender D-Flip-Flops 22 geschaltet. Der vierte Doppelinverter 26 liegt zwischen dem invertierenden Takteingang CLK des vierten D-Flip-Flops 22 und dem Daten-Taktausgang DTA des Schieberegisters 20. Die Takteingänge CLK der ersten drei D-Flip-Flops 22 sind nichtinvertierend. Der Takteingang CLK des ersten D-Flip-Flops 22 liegt ferner am Daten-Takteingang DTE des Schieberegisters 20, mit dem der Ausgang des Taktgebers 24 verbunden ist.

Das Schieberegister 20 kann erweitert werden bzw. mit einem weiteren Schieberegister verkettet werden, indem der serielle Datenausgang SDA mit dem seriellen Dateneingang SDE des nachfolgenden Schieberegisters und der Daten-Taktausgang DTA mit dem Daten-Takteingang DTE des nachfolgenden Registers verbunden werden.

Bei dieser in Fig. 2 gezeigten Schaltungsanordnung sind sämtliche den Takteingängen CLK der verschiedenen D-Flip-Flops 22 zugeführten Taktsignale $T_{s1}$-$T_{s4}$ untereinander zeitversetzt. Die jeweilige Zeitverzögerung zwischen dem einem D-Flip-Flop 22 zugeführten Taktsignal $T_{si}$ und dem dem nachfolgenden D-Flip-Flop 22 zugeführten Taktsignal $T_{si+1}$ ist durch die Laufzeit des betreffenden Doppelinverters 26 bestimmt. Diese ist so bemessen, daß die D-Flip-Flops 22 nicht gleichzeitig geschaltet werden. Ferner ist die Laufzeit eines jeweiligen Doppelinverters 26 vorzugsweise so bemessen, daß sie kleiner als die Differenz zwischen der minimalen Laufzeit eines D-Flip-Flops 22 und der Daten-Haltezeit ist. Damit ist sichergestellt, daß ein jeweiliges D-Flip-Flop 22 mit einem Taktimpuls nur ein Bit in der Flip-Flop-Kette weiterschiebt, wodurch Überlaufprobleme in Logikschaltungen vermieden werden.

Nachdem bei einer solchen Anordnung sichergestellt ist, daß jeweils nur ein D-Flip-Flop 22 seinen jeweiligen Zustand ändern kann, werden mögliche Einbrüche und Schwankungen der Betriebsspannung auf ein Minimum herabgesetzt. Es hat sich gezeigt, daß mit einer solchen Schaltungsanordnung das Schaltrauschen um etwa 90% verringert wird.

Ist eine derart hohe Rauschverringerung nicht erforderlich, so kann ein einfacherer Aufbau gewählt werden, bei dem z.B. nur zwischen jedes n-te D-Flip-Flop 22 und das jeweils darauffolgende Flip-Flop ein Doppelinverter 26 geschaltet wird, wobei n eine ganze Zahl größer 1 ist.

Während bei dem in Fig. 2 gezeigten Schieberegister 20 die gesamte Taktverzögerung gleich der Summe der Laufzeiten der einzelnen Doppelinverter 26 ist, wird durch die in Fig. 3 gezeigte Ausführungsform eines erfindungsgemäßen Schieberegisters die resultierende Laufzeit gering gehalten.

Dieses in Fig. 3 gezeigte Schieberegister 30 enthält wiederum vier miteinander verkettete dynamische D-Flip-Flops $32_1$-$32_4$. Der Q-Ausgang eines vorangehenden D-Flip-Flops $32_i$ ist mit dem D-Eingang des nachfolgenden D-Flip-Flops $32_{i+1}$ verbunden. Der D-Eingang des ersten D-Flip-Flops $32_1$ bildet den seriellen Dateneingang SDE und der Q-Ausgang des letzten D-Flip-Flops $32_4$ den seriellen Datenausgang des Schieberegisters 30. Die D-Flip-Flops $32_1$-$32_4$ besitzen differenzierende oder dynamische Takteingänge CLK, wobei die Takteingänge CLK der ersten drei D-Flip-Flops $32_1$-$32_3$ wiederum nichtinvertierend und der Takteingang des vierten D-Flip-Flops $32_4$ invertierend ist.

Die Takteingänge CLK der D-Flip-Flops $32_1$-$32_4$ sind ebenso wie bei der Ausführung gemäß der Fig. 2 über eine gemeinsame Taktleitung TL mit einem Taktgeber 34 verbunden. Diese Taktleitung TL ist nun aber derart verzweigt, daß über einen Leitungszweig $Z_a$ die beiden außenliegenden D-Flip-Flops $32_1$, $32_4$ und über einen weiteren Leitungszweig $Z_b$ die beiden dazwischenliegenden D-Flip-Flops $32_2$, $32_3$ mit dem zugeordneten Taktgeber 34 verbunden werden. Hierbei ist nur in dem weiteren Leitungszweig $Z_b$ ein Doppelinverter 36 als Verzögerungsglied vorgesehen. Dieser Doppelinverter 36 liegt zwischen dem Takteingang CLK des ersten D-Flip-Flops $32_1$ einerseits und den Takteingängen CLK der beiden mittleren D-Flip-Flops $32_2$, $32_3$ andererseits. Damit tritt das Taktsignal $Ts_4$ des letzten D-Flip-Flops $32_4$ gleichzeitig mit dem Taktsignal $Ts_1$ des ersten D-Flip-Flops $32_1$ auf, während das Taktsignal $Ts_3$ des dritten D-Flip-Flops $32_3$ gleichzeitig mit dem Taktsignal $Ts_2$ des zweiten D-Flip-Flops $32_2$ auftritt. Demgegenüber sind die Taktsignale $Ts_1$, $Ts_4$ der durch die beiden äußeren D-Flip-Flops $32_1$, $32_4$ gebildeten Gruppe von Elementarspeichern gegenüber den Taktsignalen $Ts_2$, $Ts_3$ der durch die beiden mittleren D-Flip-Flops $32_2$, $32_3$ gebildeten Gruppe von Elementarspeichern zeitversetzt. Die Zeitverzögerung ist durch die Laufzeit des Doppelinverters 36 bestimmt. Der mit dem Taktgeber 34 verbundene Daten-Takteingang DTE ist somit unmittelbar mit den Takteingängen CLK der beiden äußeren D-Flip-Flops $32_1$, $32_4$ verbunden.

Für eine Erweiterung des Schieberegisters 30 bzw. den Anschluß eines weiteren Schieberegisters ist zwischen den Daten-Taktausgang DTA und den über den Leitungszweig $Z_a$ gespeisten Takteingang CLK des letzten D-Flip-Flops $32_4$ ein weiterer Doppelinverter 36 geschaltet. Damit ist sichergestellt, daß auch die Taktsignale für unterschiedliche Schalteinheiten bzw. Schieberegisterabschnitte untereinander zeitversetzt sind.

Bei diesem in Fig. 3 gezeigten Schieberegister 30 ist das Schaltrauschen im Vergleich zu dem in Fig. 1 gezeigten herkömmlichen Schieberegister ebenfalls deutlich reduziert, wobei zusätzlich im Vergleich zum Schieberegister der Fig. 2 eine deutlich kürzere resultierende Laufzeit erzielt wird.

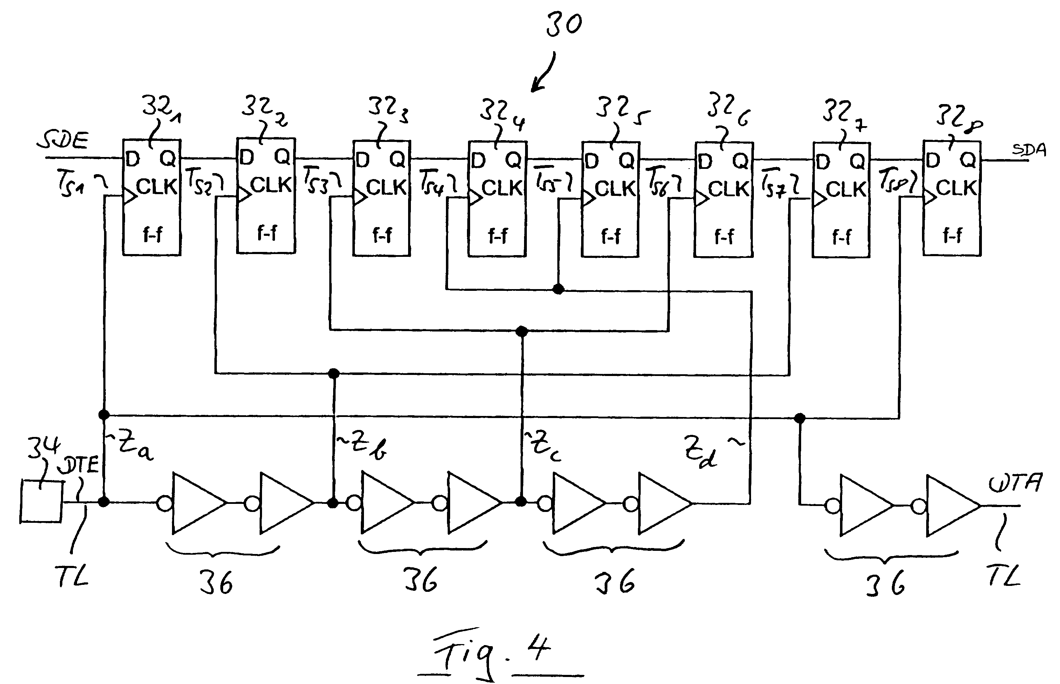

Fig. 4 zeigt eine weitere Ausführungsform eines erfindungsgemäßen Schieberegisters 30, die der in Fig. 3 dargestellten Ausführungsform ähnlich ist. Dieses in Fig. 5 dargestellte Schieberegister 30 enthält acht miteinander verkettete dynamische D-Flip-Flops $32_1$-$32_8$. Der Q-Ausgang eines vorangehenden D-Flip-Flops $32_i$ ist wiederum mit dem D-Eingang des nachfolgenden D-Flip-Flops $32_{i+1}$ verbunden. Der D-Eingang des ersten D-Flip-Flops $32_1$ bildet den seriellen Dateneingang SDE und der Q-Ausgang des letzten D-Flip-Flops $32_8$ den seriellen Datenausgang SDA des Schieberegisters 30. Die D-Flip-Flops $32_1$-$32_8$ besitzen differenzierende oder dynamische Takteingänge CLK, wobei beispielsweise die Takteingänge CLK der ersten sieben D-Flip-Flops $32_1$-$32_7$ wiederum nichtinvertierend und der Takteingang des achten D-Flip-Flops $32_8$ invertierend sein können.

Die Takteingänge CLK der D-Flip-Flops $32_1$-$32_8$ sind ebenso wie bei der Ausführung der Fig. 3 über eine gemeinsame Taktleitung TL mit einem Taktgeber 34 verbunden. Die Taktleitung TL enthält mehrere in Serie geschaltete Doppelinverter 36 und mehrere Leitungszweige $Z_a$-$Z_d$, wobei zwischen die beiden benachbarten Leitungszweige eines jeweiligen Leitungszweigpaares $Z_a$, $Z_b$; $Z_b$, $Z_c$ bzw. $Z_c$, $Z_d$ jeweils ein Doppelinverter 36 geschaltet ist. Die Takteingänge CLK der beiden in der Kette 32 von D-Flip-Flops $32_1$-$32_8$ außenliegenden D-Flip-Flops 321, $32_8$ sind gemeinsam über den Leitungszweig $Z_a$ der Taktleitung TL mit dem Taktgeber 34 verbunden. Die Takteingänge CLK der beiden folgenden, weiter innen liegenden D-Flip-Flops $32_2$, $32_7$ sind gemeinsam über den Leitungszweig $Z_b$ und einen Doppelinverter 36 der Taktleitung TL mit dem Taktgeber 34 verbunden. Die beiden folgenden, weiter innen liegenden D-Flip-Flops $32_3$, $32_6$ sind gemeinsam über den Leitungszweig $Z_c$ und zwei Doppelinverter 36 der Taktleitung TL mit dem Taktgeber 34 verbunden. Schließlich sind die beiden innenliegenden D-Flip-Flops $32_4$, $32_5$ gemeinsam über den Leitungszweig $Z_d$ und drei Doppelinverter 36 der Taktleitung TL mit dem Taktgeber 34 verbunden. Die Kette von Elementarspeichern kann in der beschriebenen Weise durch weitere Elementarspeicher erweitert werden. Für den Anschluß einer weiteren Kette von Elementarspeichern oder eines weiteren Schieberegisters ist zwischen den Daten-Taktausgang DTA und den unmittelbar durch den Ausgang des Taktgebers 34 gebildeten Daten-Takteingang DTE bzw. den unmittelbar mit diesem verbundenen Leitungszweig $Z_a$ ein weiterer Doppelinverter 36 geschaltet.

Diese Ausführungsvariante stellt somit praktisch eine durch vier D-Flip-Flops erweiterte Kette von Elementarspeichern der in Fig. 3 gezeigten Art dar. Durch eine solche Kette von Elementarspeichern kann beispielsweise wiederum ein Schieberegister gebildet sein.

Grundsätzlich können mehrere der in den Figuren 3 oder 4 gezeigten Schaltungseinheiten 20, 30, 40 miteinander verkettet oder hintereinandergeschaltet oder die gezeigten Schaltungseinheiten 20, 30, 40 entsprechend erweitert sein. Die Erfindung ist mit besonderem Vorteil bei Hochgeschwindigkeits-CMOS-Schaltungen einsetzbar, und sie ermöglicht die Unterbringung einer größeren Anzahl von Schaltungseinheiten bzw. Elementarspeichern in einer einzigen Packung. Das resultierende Schaltrauschen ist trotz der höheren Packungsdichte minimal.

## Patentansprüche

1. Schaltungsanordnung mit wenigstens einer Schaltungseinheit (20, 30) wie einem Register, einer Speicherzelle, einer Speicheranordnung oder dergleichen, die mehrere taktgesteuerte verkettete Elementarspeicher (22, 32) enthält, deren Takteingänge (CLK) mit einer gemeinsamen Taktleitung (TL) in Verbindung stehen, wobei die den Takteingängen (CLK) der verschiedenen Elementarspeicher (22, 32) in Datenflußrichtung zugeführten Taktsignale ($Ts_1$-$Ts_4$) zumindest teilweise zeitlich so versetzt sind, daß eventuelle Zustandsänderungen der betreffenden Elementarspeicher (22, 32) zeitversetzt ausgelöst werden, **dadurch gekennzeichnet**, daß die den Takteingängen (CLK) benachbarter Elementarspeicher (22, 32) zugeführten Taktsi-

gnale ($Ts_1$-$Ts_4$) um weniger als die Differenz zwischen der minimalen Laufzeit der Elementarspeicher (22, 32) und der Daten-Haltezeit zeitversetzt sind, wobei den Elementarspeichern (32) gruppenweise zeitgleiche Taktsignale ($Ts_1$-$Ts_4$) zugeführt sind und daß die Taktsignale ($Ts_1$-$Ts_4$) der verschiedenen Gruppen von Elementarspeichern (32) zeitversetzt sind.

2.  Schaltungsanordnung nach Anspruch 1, **dadurch gekennzeichnet,** daß die Taktleitung (TL) wenigstens ein Verzögerungsglied (26, 36) enthält, das zwischen die Gruppen von Elementarspeichern (22, 32) geschaltet ist, um deren Takteingängen (CKL) entsprechend zeitversetzte Taktsignale ($Ts_1$-$Ts_4$) zu liefern.

3.  Schaltungsanordnung nach einem der vorhergehenden Ansprüche, **dadurch gekennzeichnet,** daß die Takteingänge (CLK) der verschiedenen Elementarspeicher (22, 32) des Schieberegisters (20, 30) mit einer wenigstens ein Verzögerungsglied (26, 36) enthaltenden gemeinsamen Taktleitung (TL) in Verbindung stehen und daß zwischen wenigstens zwei Elementarspeicher (22, 32) ein solches Verzögerungsglied (26, 36) geschaltet ist.

4.  Schaltungsanordnung nach Anspruch 3, **dadurch gekennzeichnet,** daß nur zwischen jeden n-ten Elementarspeicher (32) und den darauffolgenden Elementarspeicher (32) jeweils ein Verzögerungsglied (36) geschaltet ist, wobei n eine ganze Zahl größer Eins ist.

5.  Schaltungsanordnung nach Anspruch 3, **dadurch gekennzeichnet**, daß die Taktleitung (TL) so verzweigt ist, daß über einen Leitungszweig ($Z_a$) die beiden außenliegenden Elementarspeicher ($32_1$, $32_4$) und über einen weiteren Leitungszweig ($Z_b$) dazwischenliegende Elementarspeicher ($32_2$, $32_3$) mit einem zugeordneten Taktgeber (34) verbunden sind, und daß nur in dem weiteren Leitungszweig ($Z_b$) wenigstens ein Verzögerungsglied (36) vorgesehen ist.

6.  Schaltungsanordnung nach einem der vorhergehenden Ansprüche, **dadurch gekennzeichnet**, daß der am Ausgang der Schaltungseinheit (30) vorgesehene Elementarspeicher ($32_4$) einen invertierenden Takteingang (CLK) aufweist.

7.  Schaltungsanordnung nach einem der vorhergehenden Ansprüche, **dadurch gekennzeichnet**, daß wenigstens zwei Schaltungseinheiten (20, 30) hintereinandergeschaltet sind und daß auch die den Takteingängen (CKL) der verschiedenen Schaltungseinheiten (20, 30) zugeführten Taktsignale ($Ts_1$-$Ts_4$) zumindest teilweise zeitversetzt

sind.

8.  Schaltungsanordnung nach einem der vorhergehenden Ansprüche, **dadurch gekennzeichnet,** daß die Verzögerungsglieder jeweils einen Doppelinverter (26, 36) enthalten.

9.  Schaltungsanordnung nach einem der vorhergehenden Ansprüche, **dadurch gekennzeichnet**, daß die Elementarspeicher jeweils durch wenigstens ein Flip-Flop (22, 32) gebildet sind.

10. Schaltungsanordnung nach einem der vorhergehenden Ansprüche, **dadurch gekennzeichnet**, daß die Elementarspeicher (22, 32) dynamische oder differenzierende Takteingänge (CKL) besitzen.

11. Schaltungsanordnung nach einem der vorhergehenden Ansprüche, **dadurch gekennzeichnet**, daß die Schaltungseinheit (20, 30) eine CMOS-Schaltung ist.

12. Schaltungsanordnung nach einem der vorhergehenden Ansprüche, **dadurch gekennzeichnet**, daß die Schaltungseinheit ein Schieberegister (20, 30) ist.

13. Schaltungsanordnung mit wenigstens einer Schaltungseinheit (30) wie einem Register, einer Speicherzelle, einer Speicheranordnung oder dergleichen, die eine Kette von taktgesteuerten Elementarspeichern ($32_1$-$32_8$) enthält, deren Takteingänge (CLK) mit einem Taktgeber (34) gekoppelt sind, und der Schaltungseinheit (30) zugeordneten Schaltungsmitteln (36), die derart ausgebildet sind, daß den Takteingängen (CKL) zugeführte Taktsignale ($Ts_1$-$Ts_8$) zeitlich so versetzt sind, daß eventuelle Zustandsänderungen der betreffenden Elementarspeicher ($32_1$-$32_8$) zeitversetzt ausgelöst werden, **dadurch gekennzeichnet,** daß die zeitversetzte Auslösung so erfolgt, daß ausgehend von den beiden äußeren Enden der Kette die jeweils weiter außen liegenden Elementarspeicher ($32_1$-$32_8$) ihren Zustand früher ändern als die jeweils angrenzenden, weiter innen liegenden Elementarspeicher ($32_1$-$32_8$).

14. Schaltungsanordnung nach Anspruch 13, wobei den ein Schieberegister bildenden Elementarspeichern ($32_1$-$32_8$) die Taktsignale ($Ts_1$-$Ts_8$) derart zugeführt werden, daß zunächst wenigstens die ein- und ausgangsseitig angeordneten Elementarspeicher ($32_1$-$32_8$) zeitgleich ihren Zustand ändern und daß danach die jeweils weiter innen angeordneten Elementarspeicher ($32_1$-$32_8$) ihren Zustand ändern.

## Claims

1. Circuit arrangement with at least one circuit unit (20,30) such as a register, a memory cell, a memory arrangement or the like, which contains a plurality of clocked, interlinked elementary stores (22,32) whose clock inputs (CLK) are connected to a common clock line (TL), the clock signals ($Ts_1$-$Ts_4$) fed to the clock inputs (CLK) of the various elementary stores (22,32) in the direction of data flow being at least partially staggered over time such that possible changes of state of the relevant elementary stores (22,32) are triggered in a manner staggered over time, characterized in that the clock signals ($Ts_1$-$Ts_4$) fed to the clock inputs (CLK) of neighbouring elementary stores (22,32) are staggered over time by less than the difference between the minimum propagation delay of the elementary stores (22,32) and the data hold time, the elementary stores (32) being fed contemporaneous clock signals ($Ts_1$-$Ts_4$) in groups, and in that the clock signals ($Ts_1$-$Ts_4$) of the various groups of elementary stores (32) are staggered over time.

2. Circuit arrangement according to Claim 1, characterized in that the clock line (TL) contains at least one delay element (26,36), which is connected between the groups of elementary stores (22,32) in order to supply the clock inputs (CKL) thereof with clock signals ($Ts_1$ $Ts_4$) correspondingly staggered over time.

3. Circuit arrangement according to one of the preceding claims, characterized in that the clock inputs (CLK) of the various elementary stores (22,32) of the shift register (20,30) are connected to a common clock line (TL) containing at least one delay element (26,36) and in that such a delay element (26,36) is connected between at least two elementary stores (22,32).

4. Circuit arrangement according to Claim 3, characterized in that a respective delay element (36) is connected only between each nth elementary store (32) and the succeeding elementary store (32), where n is a whole number greater than one.

5. Circuit arrangement according to Claim 3, characterized in that the clock line (TL) is branched in such a way that the two outer elementary stores ($32_1$,$32_4$) are connected to an assigned clock generator (34) via one line branch ($Z_a$) and elementary stores ($32_2$, $32_3$) situated in between are connected to the said assigned clock generator (34) via a further line branch ($Z_b$), and in that at least one delay element (36) is provided only in the further line branch ($Z_b$).

6. Circuit arrangement according to one of the preceding claims, characterized in that the elementary store ($32_4$) provided at the output of the circuit unit (30) has an inverting clock input (CLK).

7. Circuit arrangement according to one of the preceding claims, characterized in that at least two circuit units (20,30) are connected in series, and in that the clock signals ($Ts_1$-$Ts_4$) fed to the clock inputs (CKL) of the various circuit units (20,30) are also at least partially staggered over time.

8. Circuit arrangement according to one of the preceding claims, characterized in that the delay elements each contain a double inverter (26,36).

9. Circuit arrangement according to one of the preceding claims, characterized in that the elementary stores are each formed by at least one flip-flop (22,32).

10. Circuit arrangement according to one of the preceding claims, characterized in that the elementary stores (22,32) have dynamic or differentiating clock inputs (CKL).

11. Circuit arrangement according to one of the preceding claims, characterized in that the circuit unit (20,30) is a CMOS circuit.

12. Circuit arrangement according to one of the preceding claims, characterized in that the circuit unit is a shift register (20,30).

13. Circuit arrangement having at least one circuit unit (30) such as a register, a memory cell, a memory arrangement or the like, which contains a chain of clocked elementary stores ($32_1$-$32_8$), whose clock inputs (CLK) are coupled to a clock generator (34), and circuit means (36) which are assigned to the circuit unit (30) and are designed in such a way that clock signals ($Ts_1$-$Ts_8$) fed to the clock inputs (CKL) are staggered over time such that possible changes of state of the relevant elementary stores ($32_1$-$32_8$) are triggered in a manner staggered over time, characterized in that the triggering in a manner staggered over time is effected in such a way that, proceeding from the two outer ends of the chain, the respective elementary stores ($32_1$-$32_8$) situated right on the outer ends change their state earlier than the respective adjoining elementary stores ($32_1$-$32_8$) situated further in.

14. Circuit arrangement according to Claim 13, the clock signals ($Ts_1$-$Ts_8$) being fed to the elementary stores ($32_1$-$32_8$) forming a shift register in such a way that first of all at least the elementary stores ($32_1$-$32_8$) arranged on the input and output sides change their state contemporaneously, and that afterwards the respective elementary stores ($32_1$-$32_8$) arranged further in change their state.

## Revendications

**1.** Circuiterie comprenant au moins une unité de circuit (20, 30) telle qu'un registre, une cellule de mémoire, un système de mémorisation ou similaire, qui comprend plusieurs mémoires élémentaires (22, 32) enchaînées, commandées par horloge, dont les entrées d'horloge (CLK) sont en liaison avec une ligne d'horloge commune (TL), les signaux d'horloge ($Ts_1$ à $Ts_4$) envoyés aux entrées d'horloge (CLK) des différentes mémoires élémentaires (22, 32) dans le sens de la circulation des données étant au moins partiellement décalés dans le temps de telle manière que les éventuels changements d'état des mémoires élémentaires (22, 32) concernées soient déclenchés à des instants décalés dans le temps, caractérisée en ce que les signaux d'horloge ($Ts_1$ à $Ts_4$) envoyés aux entrées d'horloge (CLK) des mémoires élémentaires (22, 32) adjacentes sont décalés dans le temps de moins de la différence entre le temps d'exploitation minimum des mémoires élémentaires (22, 32) et le temps de retenue des données, des signaux d'horloge ($Ts_1$ à $Ts_4$) de même instant étant transmis aux mémoires élémentaires (32) par groupes, et les signaux d'horloge ($Ts_1$ à $Ts_4$) des différents groupes de mémoires élémentaires (32) étant décalés dans le temps.

**2.** Circuiterie selon la revendication 1, caractérisée en ce que la ligne d'horloge (TL) comprend au moins un élément de retard (26, 36) qui est connecté entre les groupes de mémoires élémentaires (22, 32) pour délivrer à leurs entrées d'horloge (CLK) des signaux d'horloge ($Ts_1$ à $Ts_4$) décalés dans le temps de façon correspondante.

**3.** Circuiterie selon une des revendications précédentes, caractérisée en ce que les entrées d'horloge (CLK) des différentes mémoires élémentaires (22, 32) du registre à décalage (20, 30) sont en liaison avec une ligne d'horloge (TL) commune qui comprend au moins un élément de retard (26, 36), et en ce qu'un tel élément de retard (26, 36) est connecté entre au moins deux mémoires élémentaires (22, 32).

**4.** Circuiterie selon la revendication 3, caractérisée en ce qu'il n'est prévu un élément de retard (36) qu'entre chaque n-ième mémoire élémentaire (32) et la mémoire élémentaire (32) suivante, $\underline{n}$ étant un nombre entier supérieur à 1.

**5.** Circuiterie selon la revendication 3, caractérisée en ce que la ligne d'horloge (TL) est ramifiée de telle manière que les deux mémoires élémentaires ($32_1$, $32_4$) extérieures sont connectées à un générateur de rythme d'horloge (34) correspondant par une branche $Z_a$ de la ligne et les mémoires élémentaires ($32_2$, $32_3$) interposées entre elles sont connectées à un générateur de rythme d'horloge (34) correspondant par une autre branche ($Z_b$) de la ligne, et en ce qu'il n'est prévu au moins un élément de retard (36) que dans l'autre branche ($Z_b$) de la ligne.

**6.** Circuiterie selon une des revendications précédentes, caractérisée en ce que la mémoire élémentaire ($32_4$) prévue à la sortie de l'unité de circuit (30) présente une entrée d'horloge (CLK) inverseuse.

**7.** Circuiterie selon une des revendications précédentes, caractérisée en ce qu'au moins deux unités de circuit (20, 30) sont connectées l'une à la suite de l'autre, et en ce que les signaux d'horloge ($Ts_1$ à $Ts_4$) transmis aux entrées d'horloge (CLK) des différentes unités de circuit (20, 30) sont décalés au moins partiellement dans le temps.

**8.** Circuiterie selon une des revendications précédentes, caractérisée en ce que les éléments de retard contiennent chacun un inverseur double (26, 36).

**9.** Circuiterie selon une des revendications précédentes, caractérisée en ce que les mémoires élémentaires sont formées chacune par au moins une bascule (22, 32).

**10.** Circuiterie selon une des revendications précédentes, caractérisée ce que les mémoires élémentaires (22, 32) possèdent des entrées d'horloge (CLK) dynamiques ou différentielles.

**11.** Circuiterie selon une des revendications précédentes, caractérisée en ce que l'unité de circuit (20, 30) est un circuit CMOS.

**12.** Circuiterie selon une des revendications précédentes, caractérisée en ce que l'unité de circuit est un registre à décalage (20, 30).

**13.** Circuiterie comprenant au moins une unité de circuit (30) telle qu'un registre, une cellule de mémoire, un système de mémorisation ou analogue, qui comprend une chaîne de mémoires élémentaires ($32_1$ à $32_8$) commandées par horloge, dont les entrées d'horloge (CLK) sont connectées à un générateur de rythme d'horloge (34), ainsi que des moyens de circuit (36) associés à l'unité de circuit (30), qui sont constitués de manière que des signaux d'horloge ($Ts_1$ à $Ts_8$) transmis aux entrées d'horloge (CLK) sont décalés dans le temps de telle manière que d'éventuels changements d'état des

mémoires élémentaires concernées ($32_1$ à $32_8$) soient déclenchés de façon décalée dans le temps, caractérisée en ce que le déclenchement décalé dans le temps s'effectue de telle manière qu'en partant des deux extrémités extérieures de la chaîne, les mémoires élémentaires ($32_1$ à $32_8$) situées plus loin vers l'extérieur changent d'état plus tôt que les mémoires élémentaires ($32_1$ à $32_8$) respectivement adjacentes qui sont situées plus loin vers l'intérieur.

14. Circuiterie selon la revendication 13, dans laquelle les signaux d'horloge ($Ts_1$ à $Ts_8$) sont transmis aux mémoires élémentaires ($32_1$ à $32_8$) qui forment un registre à décalage de telle manière que, tout d'abord, au moins les mémoires élémentaires ($32_1$ à $32_8$) disposées côté entrée et côté sortie changent d'état en même temps, et que les mémoires élémentaires ($32_1$ à $32_8$) qui sont disposées plus loin vers l'intérieur changent d'état plus tard.

## FIG. 1

## FIG. 2

## FIG. 3

Fig. 4